# EUROPEAN PATENT SPECIFICATION

(11) **EP 4 010 922 B1**
(45) Date of publication and mention of the grant of the patent: **01.04.2026**
(21) Application number: 20852230.0
(22) Date of filing: 07.08.2020
(51) Int. Cl.: H01L 23/367, H01L 23/42

(54) **IC HEAT SINK ASSEMBLY**
IC-KÜHLKÖRPER-ANORDNUNG
ENSEMBLE DISSIPATEUR THERMIQUE POUR CIRCUIT INTÉGRÉ

(30) Priority: 09.08.2019 CN 201921293627 U
(43) Date of publication of application: 15.06.2022
(73) Proprietor: Harman International Industries, Incorporated, Stamford, CT 06901 (US)
(72) Inventor: CHU, Jinqiang, Suzhou, Jiangsu 215024 (CN); MIESLINGER, Alexander, 85356 Freising (DE); WU, Jiale, Suzhou, Jiangsu 215024 (CN); HUANG, Huobing, Suzhou, Jiangsu 215024 (CN)
(74) Representative: Kraus & Lederer PartGmbB
(86) International application number: PCT/CN2020/107762
(87) International publication number: WO 2021/027718

(56) References cited:
- WO-A1-01/20675
- CN-A- 105 744 801
- CN-U- 202 713 872
- CN-U- 202 713 872
- CN-U- 208 690 235
- CN-Y- 2 917 202
- CN-Y- 2 917 202
- JP-A- 2016 174 481
- US-A1- 2006 215 369
- US-A1- 2006 238 984

## Description

### Technical field

The present disclosure relates to an IC heat sink assembly. More specifically, the present disclosure relates to an IC heat sink assembly that can prevent an excessive thermally conductive interface material from overflowing.

### Background

Special heat sinks or heat sink fins are required for heat dissipation of some IC components with high heat consumption, such as power chips used in car power amplifiers. Generally, contact surfaces of a heat sink and an IC component need to be closely attached and a thermally conductive interface material is provided between the attached surfaces to maximize the heat dissipation effect. CN 202 713 872 U (GUANDIN TECHNOLOGY CO., LTD.) 30 January 2013 (2013-01-30) discloses a prior art IC heat sink assembly.

It is often a problem to control the amount of the thermally conductive interface material between the IC component and the heat sink. An insufficient amount of the thermally conductive interface material will lead to poor thermal contact between the IC component and the heat sink, thereby affecting the heat dissipation effect. An excessive thermally conductive interface material will cause the thermally conductive interface material to overflow between the IC component and the heat sink. Especially when a relatively thin thermally conductive interface material such as thermally conductive silicone grease is used, the excessive thermally conductive interface material may overflow to pins of the component to make the component disabled in function.

Therefore, it is desirable to ensure a thermal contact between the IC component and the heat sink, while preventing the excessive thermally conductive interface material from overflowing.

### Summary of the Disclosure

The present disclosure is directed to an IC heat sink assembly that can ensure a thermal contact between the IC component and the heat sink while preventing an excessive thermally conductive interface material from overflowing.

According to an aspect of the present disclosure, an IC heat sink assembly is provided, according to claim 1. Preferred embodiments are given by the dependent claims.

### Brief Description of the Drawings

FIG. 1 is a cross-sectional view showing an IC component provided with a heat sink.
FIGS. 2-5 show a first embodiment according to the present disclosure, where FIG. 2 shows an IC chip, FIG. 3 shows a heat sink, and FIGS. 4-5 show assembly configurations of this embodiment at different positions in a cross-sectional view.
FIGS. 6-9 show a second embodiment according to the present disclosure, where FIG. 6 shows an IC chip, FIG. 7 shows a heat sink, and FIGS. 8-9 show assembly configurations of this embodiment at different positions in a cross-sectional view.

### Detailed Description

Embodiments of the present disclosure will be described in detail below. Examples of the embodiments are shown in the accompanying drawings, where the same or similar reference numerals always indicate the same or similar elements or elements with the same or similar functions. The embodiments described below with reference to the accompanying drawings are illustrative, which are only used to explain the present disclosure, and cannot be understood as a limitation to the present disclosure.

Unless otherwise defined, the technical terms or scientific terms used here should be the ordinary meanings understood by those of ordinary skill in the field of the present disclosure. In the description of the present disclosure, it should be understood that an orientation or positional relationship indicated by the terms "center," "longitudinal," "lateral," "upper," "lower," "front," "rear," "left," "right," "vertical," "horizontal," "top," "bottom," "inner," "outer," etc. is an orientation or positional relationship shown based on the accompanying drawings, is only for the convenience of describing the present disclosure and simplifying the description, rather than indicating or implying that a device or element referred to must have a specific orientation or be constructed and operated in a specific orientation, and therefore cannot be understood as a limitation to the present disclosure. In addition, the terms "first" and "second" are only used for descriptive purposes, and cannot be understood as indicating or implying relative importance.

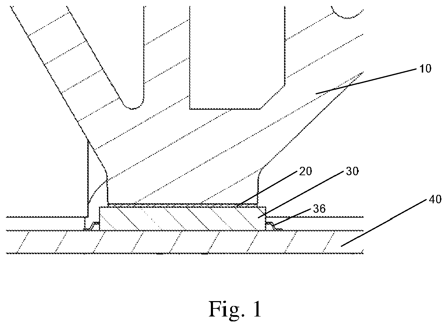

FIG. 1 is a cross-sectional view showing an IC component provided with a heat sink. As shown in the figure, IC component 30, such as an IC chip, is mounted (soldered) on printed circuit board 40. Heat sink 10 is mounted on IC component 30, and thermally conductive interface material 20 is provided between heat sink 10 and IC component 30 to increase the thermal conduction therebetween. In order to ensure the thermal conduction between heat sink 10 and IC component 30, thermally conductive interface material 20 between heat sink 10 and IC component 30 must be sufficient.

However, in actual operations, the thermally conductive interface material between heat sink 10 and IC component 30 is excessive sometimes due to operational errors. In addition, uneven application of thermally conductive interface material 20 may also cause a local excess of thermally conductive interface material 20. Excessive thermally conductive interface material 20 will overflow between the IC component and the heat sink, especially when a relatively thin thermally conductive interface material such as thermally conductive silicone grease is used. The overflowing thermally conductive interface material may flow to pins 36 of the component, thereby causing the component to be disabled in function.

In order to solve the problem of the overflow of the thermally conductive interface material, a groove is provided on a contact surface between the heat sink and the IC component in the present disclosure to accommodate the excessive thermally conductive interface material. The groove allows a slight excess of thermally conductive interface material to be provided between the heat sink and the IC component, which ensures that there is a sufficient thermally conductive interface material between the IC component and the heat sink to achieve a good thermal contact. Moreover, the groove can accommodate the excessive thermally conductive interface material, thereby preventing the excessive thermally conductive interface material from overflowing.

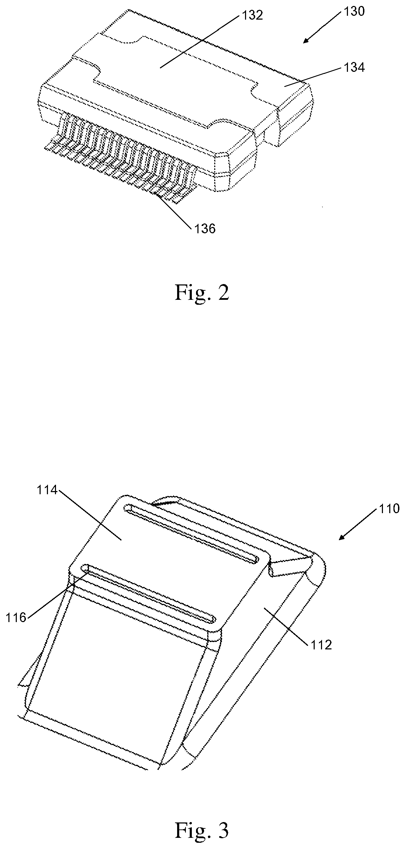

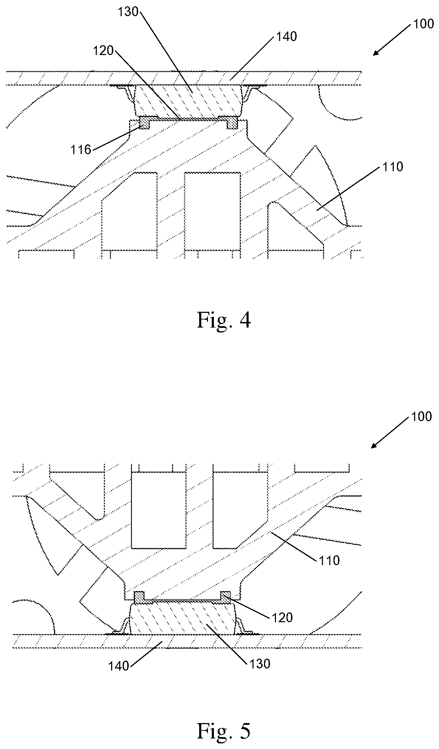

FIGS. 2-5 show a first embodiment according to the present disclosure, where FIG. 2 shows IC chip 130, FIG. 3 shows heat sink 110, and FIGS. 4-5 show assembly configurations of this embodiment in a cross-sectional view.

As shown in FIG. 2, IC chip 130 includes a chip body, chip heat dissipation surface 132, chip packaging housing 134, and chip pins 136. As shown in the figure, chip packaging housing 134 is located on both sides of chip heat dissipation surface 132 on an upper surface of IC chip 130, and chip heat dissipation surface 132 is slightly higher than chip packaging housing 134. For a chip that does not generate much heat, chip heat dissipation surface 132 is sufficient to dissipate heat generated inside the chip to the surrounding environment. For a chip that generates much heat, a heat sink is needed to enhance the heat dissipation from chip heat dissipation surface 132 to the surrounding environment.

FIG. 3 shows heat sink 110 for IC chip 130. Heat sink 110 includes heat sink body 112, contact surface 114 for contacting with heat dissipation surface 132 of IC chip 130, and two grooves 116 provided in contact surface 114. As shown in the figure, the positions of two grooves 116 respectively correspond to the position of chip packaging housing 134 of IC chip 130 on both sides of chip heat dissipation surface 132, so that when heat sink 110 is mounted on IC chip 130, two grooves 116 are respectively located in chip packaging housing 134 on both sides.

FIGS. 4-5 show assembly configurations in a cross-sectional view, where FIG. 4 is a mounting position, and FIG. 5 is a working position. As shown in the figures, an IC component, such as IC chip 130, is soldered on printed circuit board 140. Heat sink 110 is mounted on IC chip 130. In this assembly configuration, two grooves 116 of heat sink 110 are opposite to chip packaging housing 134 on both sides of chip heat dissipation surface 132 respectively. Thermally conductive interface material 120 is provided between chip heat dissipation surface 132 of IC chip 130 and a contact surface of heat sink 110 to increase the thermal conduction between IC chip 130 and heat sink 110.

As clearly shown in FIGS. 4 and 5, excessive thermally conductive interface material 120 is accommodated in two grooves 116 so as not to overflow between IC chip 130 and heat sink 110. Since a slight excess of thermally conductive interface material is provided between heat sink 110 and IC chip 130, a good thermal contact between IC chip 130 and heat sink 110 can be ensured. In addition, two grooves 116 are located on both sides of chip heat dissipation surface 132 respectively, and are opposite to chip packaging housing 134 on both sides. Therefore, the existence of grooves 116 will not affect the heat dissipation from IC chip 130 to heat sink 110 via chip heat dissipation surface 132.

FIG. 4 shows a mounting position of the first embodiment according to the present disclosure. At the mounting position shown in FIG. 4, heat sink 110 is below IC chip 130, so that openings of contact surface 114 and groove 116 of heat sink 110 face upward. At this position, excessive thermally conductive interface material 120 is more likely to enter groove 116 under the action of gravity, thereby preventing excessive thermally conductive interface material 120 from overflowing.

FIG. 5 shows a working position of the first embodiment according to the present disclosure. At the working position shown in FIG. 5, heat sink 110 is above IC chip 130, and an opening of groove 116 of heat sink 110 faces downward. Although the opening of groove 116 faces downward, thermally conductive interface material 120 in groove 116 will not flow out of groove 116 due to surface tension or capillary action.

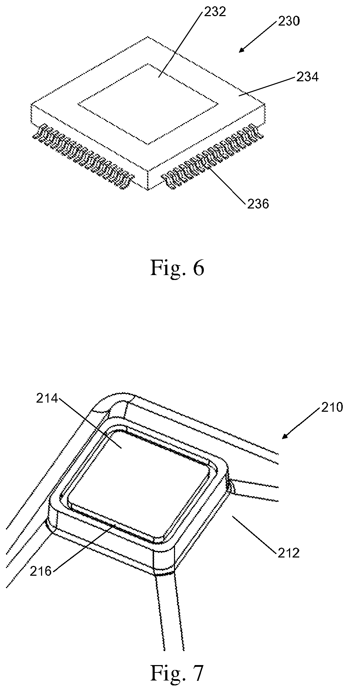

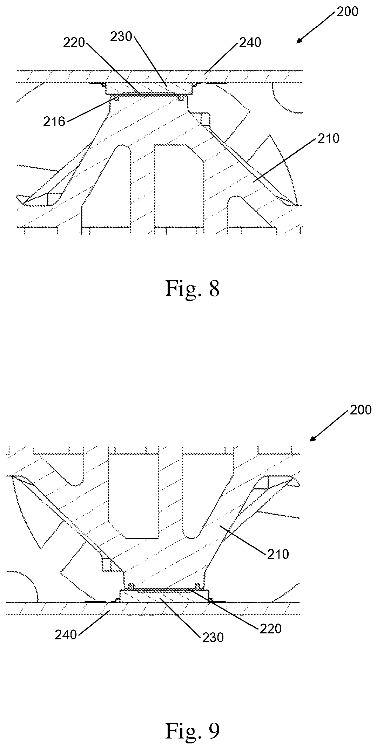

FIGS. 6-9 show a second embodiment according to the present disclosure, where FIG. 6 shows IC chip 230, FIG. 7 shows heat sink 210, and FIGS. 8-9 show assembly configurations of this embodiment in a cross-sectional view.

As shown in FIG. 6, IC chip 230 includes a chip body, chip heat dissipation surface 232, chip packaging housing 234, and chip pins 236. As shown in the figure, chip heat dissipation surface 232 is located in the middle of an upper surface of IC chip 230, and chip packaging housing 234 surrounds chip heat dissipation surface 232.

FIG. 7 shows heat sink 210 for IC chip 230. Heat sink 210 includes heat sink body 212, contact surface 214 for contacting with heat dissipation surface 232 of IC chip 230, and annular groove 216 provided in contact surface 214. As shown in the figure, the position of annular groove 216 corresponds to the position of chip packaging housing 234 of IC chip 230 around chip heat dissipation surface 232, so that when heat sink 210 is mounted on IC chip 230, annular groove 216 is located on chip packaging housing 234.

FIGS. 8-9 show assembly configurations in a cross-sectional view, where FIG. 8 is a mounting position, and FIG. 9 is a working position. As shown in the figures, an IC component, such as IC chip 230, is soldered on printed circuit board 240. Heat sink 210 is mounted on IC chip 230. In this assembly configuration, annular groove 216 is opposite to chip packaging housing 234 around chip heat dissipation surface 232. Thermally conductive interface material 220 is provided between chip heat dissipation surface 232 of IC chip 230 and a contact surface of heat sink 210 to increase the thermal conduction between IC chip 230 and heat sink 210.

As clearly shown in FIGS. 8 and 9, excessive thermally conductive interface material 220 is accommodated in annular groove 216 so as not to overflow between IC chip 230 and heat sink 210. Since a slight excess of thermally conductive interface material is provided between heat sink 210 and IC chip 230, a good thermal contact between IC chip 230 and heat sink 210 can be ensured. In addition, annular groove 216 is located around chip heat dissipation surface 232 and is opposite to chip packaging housing 234. Therefore, the existence of groove 216 will not affect the heat dissipation from IC chip 230 to heat sink 210 via chip heat dissipation surface 232.

FIG. 8 shows a mounting position of the second embodiment according to the present disclosure. At the mounting position shown in FIG. 8, heat sink 210 is below IC chip 230, so that openings of contact surface 214 and groove 116 of heat sink 210 face upward. At this position, excessive thermally conductive interface material 220 is more likely to enter groove 216 under the action of gravity, thereby preventing excessive thermally conductive interface material 220 from overflowing.

FIG. 9 shows a working position of the second embodiment according to the present disclosure. At the working position shown in FIG. 9, heat sink 210 is above IC chip 230, and an opening of groove 216 of heat sink 210 faces downward. Although the opening of groove 216 faces downward, thermally conductive interface material 220 in groove 216 will not flow out of groove 216 due to surface tension or capillary action.

The present disclosure is described for two types of IC chips in two preferred embodiments of the present disclosure. However, the present disclosure is not limited thereto, and the present disclosure may be applicable to any IC chip or IC component that requires heat dissipation.

In the two preferred embodiments of the present disclosure, the grooves on the heat sink have a specific shape and quantity. However, the present disclosure is not limited thereto, the grooves of the present disclosure may have any suitable shape and quantity, and the shape and quantity of the grooves of the present disclosure may be changed to adapt to different IC chips.

In a preferred embodiment of the present disclosure, the thermally conductive interface material is thermally conductive silicone grease. However, the present disclosure is not limited thereto. The present disclosure is suitable for various thermally conductive interface materials, especially for relatively thin thermally conductive interface materials.

In a preferred embodiment of the present disclosure, a heat sink in a specific form is shown. However, the present disclosure is not limited thereto, and the present disclosure may be used for a heat sink in any suitable form.

In a preferred embodiment of the present disclosure, the cross section of the groove is substantially square. However, the present disclosure is not limited thereto, and the cross section of the groove of the present disclosure may be rectangular, semicircular, etc.

The schematic mounting and working positions are shown in FIGS. 4-5 and 8-9 of the present disclosure. However, the present disclosure is not limited thereto, and any suitable mounting position and working position may be adopted in the present disclosure.

The foregoing descriptions are merely example embodiments adopted to illustrate the principles of the present disclosure, and are not used to limit the protection scope of the present disclosure.

## Claims

1. An IC heat sink assembly, comprising:
a heat sink (110, 210), comprising a contact surface (114, 214) and a groove (116, 216) provided in the contact surface;
an IC component (130, 230) comprising a heat dissipation surface (132, 232) and a packaging housing (134, 234) surrounding the heat dissipation surface; and
a thermally conductive interface material (120, 220) provided between the heat sink and the IC component,
wherein the heat dissipation surface of the IC component is thermally connected to the contact surface of the heat sink through the thermally conductive interface material,
**characterised in that**
the contact surface is flat, and the groove is provided at a position corresponding to the packaging housing of the IC component.

2. The IC heat sink assembly according to claim 1, wherein the groove is a closed annular groove adjacent to the edge of the contact surface.

3. The IC heat sink assembly according to claim 1, wherein the cross section of the groove is square, rectangular, or semicircular.

4. The IC heat sink assembly according to claim 1, further comprising a heat dissipation fin thermally connected to the contact surface.

5. The IC heat sink assembly according to claim 1, wherein the groove comprises two elongated grooves respectively adjacent to both sides of the contact surface.

6. The IC heat sink assembly according to claim 1, wherein the IC component is an IC chip.

7. The IC heat sink assembly according to claim 1, wherein the thermally conductive interface material is thermally conductive silicone grease.

8. The IC heat sink assembly according to claim 1, wherein a part of the thermally conductive interface material is received in the groove of the heat sink.

9. The IC heat sink assembly according to claim 1, wherein the groove of the heat sink is positioned to be opposite to the packaging housing of the IC component.

## Patentansprüche

1. IC-Kühlkörper-Anordnung, umfassend:
einen Kühlkörper (110, 210), umfassend eine Kontaktoberfläche (114, 214) und eine Nut (116, 216), die in der Kontaktoberfläche bereitgestellt ist;
eine IC-Komponente (130, 230), umfassend eine Wärmeableitungsoberfläche (132, 232) und ein Verpackungsgehäuse (134, 234), das die Wärmeableitungsoberfläche umgibt; und
ein wärmeleitendes Schnittstellenmaterial (120, 220), das zwischen dem Kühlkörper und der IC-Komponente bereitgestellt ist,
wobei die Wärmeableitungsoberfläche der IC-Komponente über das wärmeleitende Schnittstellenmaterial thermisch mit der Kontaktoberfläche des Kühlkörpers verbunden ist,
**dadurch gekennzeichnet, dass**
die Kontaktoberfläche flach ist und die Nut an einer Stelle bereitgestellt ist, die dem Verpackungsgehäuse der IC-Komponente entspricht.

2. IC-Kühlkörper-Anordnung nach Anspruch 1, wobei die Nut eine geschlossene ringförmige Nut ist, die mit dem Rand der Kontaktoberfläche benachbart ist.

3. IC-Kühlkörper-Anordnung nach Anspruch 1, wobei der Querschnitt der Nut quadratisch, rechteckig oder halbkreisförmig ist.

4. IC-Kühlkörper-Anordnung nach Anspruch 1, ferner umfassend eine Wärmeableitungsrippe, die thermisch mit der Kontaktoberfläche verbunden ist.

5. IC-Kühlkörper-Anordnung nach Anspruch 1, wobei die Nut zwei längliche Nuten umfasst, die jeweils mit beiden Seiten der Kontaktoberfläche benachbart sind.

6. IC-Kühlkörper-Anordnung nach Anspruch 1, wobei die IC-Komponente ein IC-Chip ist.

7. IC-Kühlkörper-Anordnung nach Anspruch 1, wobei das wärmeleitende Schnittstellenmaterial wärmeleitendes Silikonfett ist.

8. IC-Kühlkörper-Anordnung nach Anspruch 1, wobei ein Teil des wärmeleitenden Schnittstellenmaterials in der Nut des Kühlkörpers aufgenommen wird.

9. IC-Kühlkörper-Anordnung nach Anspruch 1, wobei die Nut des Kühlkörpers so positioniert ist, dass sie dem Verpackungsgehäuse der IC-Komponente gegenüber ist.

## Revendications

1. Ensemble dissipateur thermique pour circuit intégré (IC), comprenant :
un dissipateur thermique (110, 210), comprenant une surface de contact (114, 214) et une rainure (116, 216) fournies dans la surface de contact ;
un composant d'IC (130, 230) comprenant une surface de dissipation thermique (132, 232) et un boîtier d'encapsulation (134, 234) entourant la surface de dissipation thermique ; et
un matériau d'interface thermoconducteur (120, 220) fourni entre le dissipateur thermique et le composant d'IC,
dans lequel la surface de dissipation thermique du composant d'IC est reliée thermiquement à la surface de contact du dissipateur thermique à travers le matériau d'interface thermoconducteur,
**caractérisé en ce que**
la surface de contact est plane et la rainure est fournie dans une position correspondant au boîtier d'encapsulation du composant d'IC.

2. Ensemble dissipateur thermique pour circuit intégré (IC) selon la revendication 1, dans lequel la rainure est une rainure annulaire fermée adjacente au bord de la surface de contact.

3. Ensemble dissipateur thermique pour circuit intégré (IC) selon la revendication 1, dans lequel la section transversale de la rainure est carrée, rectangulaire ou semi-circulaire.

4. Ensemble dissipateur thermique pour circuit intégré (IC) selon la revendication 1, comprenant également une ailette de dissipation thermique reliée thermiquement à la surface de contact.

5. Ensemble dissipateur thermique pour circuit intégré (IC) selon la revendication 1, dans lequel la rainure comprend deux rainures allongées respectivement adjacentes aux deux côtés de la surface de contact.

6. Ensemble dissipateur thermique pour circuit intégré (IC) selon la revendication 1, dans lequel le composant d'IC est une puce IC.

7. Ensemble dissipateur thermique pour circuit intégré (IC) selon la revendication 1, dans lequel le matériau d'interface thermoconducteur est une graisse silicone thermoconductrice.

8. Ensemble dissipateur thermique pour circuit intégré (IC) selon la revendication 1, dans lequel une partie du matériau d'interface thermoconducteur est reçue dans la rainure du dissipateur thermique.

9. Ensemble dissipateur thermique pour circuit intégré (IC) selon la revendication 1, dans lequel la rainure du dissipateur thermique est positionnée à l'opposé du boîtier d'encapsulation du composant d'IC.
